# EUROPÄISCHE PATENTSCHRIFT

(11) **EP 1 989 560 B1**
(45) Veröffentlichungstag und Bekanntmachung des Hinweises auf die Patenterteilung: **12.03.2014**
(21) Anmeldenummer: 07703897.4
(22) Anmeldetag: 16.01.2007
(51) Int. Cl.: G01R 31/3183, G01R 35/00, G01R 31/02, G01R 31/319, G01R 31/00, G01R 31/28

(54) **VERFAHREN UND SCHALTUNGSANORDNUNG ZUR SIMULATION VON FEHLERZUSTÄNDEN IN EINEM STEUERGERÄT**
METHOD AND CIRCUIT ARRANGEMENT FOR SIMULATING FAULT STATES IN A CONTROL DEVICE
PROCEDE ET DISPOSITION EN CIRCUIT POUR LA SIMULATION D'ETATS D'ERREUR DANS UN APPAREIL DE COMMANDE

(30) Priorität: 22.02.2006 DE 102006008539
(43) Veröffentlichungstag der Anmeldung: 12.11.2008
(73) Patentinhaber: Robert Bosch GmbH, 70442 Stuttgart (DE)
(72) Erfinder: MOHR, Paul, 71384 Weinstadt-Beutelsbach (DE); JAKOBY, Henrik, 71634 Ludwigsburg (DE); KOEHRER, Mathias, 70565 Stuttgart (DE); GEISELMANN, Robert, 71394 Kernen-Stetten (DE)
(86) Internationale Anmeldenummer: PCT/EP2007/050382
(87) Internationale Veröffentlichungsnummer: WO 2007/096210

(56) Entgegenhaltungen:
- EP-A- 0 780 695
- EP-A- 0 892 438
- EP-A1- 0 367 728
- US-A- 5 214 582
- US-A- 5 798 647
- WAGNER J R: "FAILURE MODE TESTING TOOL SET FOR AUTOMOTIVE ELECTRONIC CONTROLLERS" IEEE TRANSACTIONS ON VEHICULAR TECHNOLOGY, IEEE SERVICE CENTER, PISCATAWAY, NJ, US, Bd. 43, Nr. 1, Februar 1994 (1994-02), Seiten 156-163, XP000450957 ISSN: 0018-9545

## Beschreibung

Die Erfindung betrifft ein Verfahren und eine Schaltungsanordnung zur Simulation von Fehlerzuständen in einem Steuergerät, insbesondere einem Steuergerät in einem Kraftfahrzeug.

### Stand der Technik

In Fahrzeugsteuergeräten ist ein erheblicher Teil der Software den Diagnosefunktionalitäten zugeordnet. Diese Diagnosen sollen fehlerhafte Zustände im Fahrzeug, wie beispielsweise eine Leitungsunterbrechung, erkennen und einen entsprechenden Fehlerspeichereintrag erzeugen.

Verfahren und Schaltungsanordnungen zum Überprüfen der Funktionalität elektronischer bzw. elektrischer Schaltungen sind im Stand der Techniken bekannt. Aus der Druckschrift DE 197 21366 A1 ist beispielsweise eine elektrische Schaltungsanordnung bekannt, die zur Überprüfung einer aus einem Schalter und einer Last bestehenden Serienschaltung betrieben wird. Diese umfasst eine erste Schaltung, die zur Erkennung eines ersten Zustands geeignet ist, wobei der erste Zustand einen Kurzschluss eines Verbindungspunkts zu einer Versorgungsspannung darstellt, und eine zu der ersten Schaltung parallel geschaltete, zweite Schaltung, die mit dem Verbindungspunkt verbunden ist und zur Erkennung eines zweiten oder eines dritten Zustands dient. Der zweite Zustand stellt einen Kurzschluss des Verbindungspunkts nach Masse und der dritte Zustand eine Unterbrechung des Verbindungspunkts zu der Versorgungsspannung dar.

In der Druckschrift DE 43 17 175 A1 ist eine Selbsttesteinrichtung für Speicheranordnungen, Decoder oder dergleichen, zur Anwendung in einem Online-Betrieb beschrieben.

Dabei sind Mittel zur Überprüfung einer Vielzahl von Wortleitungen und/oder Spaltenleitungen vorgesehen, wobei die Wortleitungen und/oder Spaltenleitungen mit einer Prüfmatrix verbunden sind und ein bei gleichzeitig mehr als einer aktivierten Leitung ein Fehlersignal erzeugender Fehlerdetektor mit der Prüfmatrix verbunden ist.

Ein Verfahren zum Erkennen von Fehlern eines Kraftfahrzeugs ist in der Druckschrift DE 199 59 526 A1 beschrieben. Bei diesem werden in einem Kraftfahrzeug Betriebskenngrößen und Informationen zur Charakterisierung der Betriebskenngrößen über einen bestimmten Zeitraum hinweg erfasst. Zur prädiktiven Erkennung von Fehlern wird vorgeschlagen, ein Betriebskenngrößenmuster zu erstellen, ein Betriebskenngrößenmuster in geeigneter Form zu beschreiben und die aktuell erfassten Betriebskenngrößen während des Betriebs des Kraftfahrzeugs mit dem fehlercharakteristischen Betriebskenngrößenmuster zu vergleichen.

Die Druckschrift EP 0 780 695 A2 beschreibt einen Hybrid-Scanner zur Verwendung in einem Tester und ein Testverfahren mit diesem Tester. Dieser Scanner ist über eine Befestigungseinrichtung mit der zu testenden Einrichtung zu verbinden und umfasst Halbleiterschalter und mechanische Relais, um bestimmte Defekte in der zu testenden Einrichtung zu erfassen.

Die Druckschrift US 5 798 647 beschreibt eine Testdiagnoseeinrichtung, mit der bestimmte Fehlerzustände simuliert werden können. Fehlerzustände können bspw. ein Kurzschluss oder eine Unterbrechung bei einem Anschluss sein. Hierzu werden mechanische Relais geschaltet. Die Druckschrift beschreibt, dass sämtliche Fehlerzustände mit mechanischen Relais eingestellt werden.

Die Druckschrift EP 0 892 438 A2 beschreibt ein Festkörper-Relais, das aus einer Reihe von verbundenen Paaren von LDMOSFETs besteht.

Bei der vorgestellten erfindungsgemäßen Schaltungsanordnung handelt es sich um eine elektrische Schaltung, die typische Fehler, die im Fahrzeug auftreten können, simuliert. Es sind derzeit verschiedene Schaltungsanordnungen und Verfahren zur Fehlersimulation in Kraftfahrzeugen erhältlich, wobei diese Produkte die Möglichkeit bieten, verschiedene Fehlerarten einzustellen. In der nachfolgenden Tabelle sind typische Fehlerarten aufgeführt.

**Tabelle 1**

| Nr. | Fehlerart: | Schaltung zur Erzeugung des Fehlers: |
|---|---|---|
| 1 | Leitungsunterbrechung | Öffnen der Verbindung zwischen einem Steuergeräte-Pin und einer Komponente in der Peripherie |
| 2 | Kurzschluss auf plus/minus Potential der Batteriespannung (oder einer anderen Spannung) | Verbindung des Steuergeräte-Pins mit dem plus/minus Potential der Batteriespannung (oder einer anderen Spannung) |
| 3 | Kontaktkorrosion am Steuergeräte-Pin | Hinzuschalten eines Widerstands zwischen einem Steuergeräte-Pin und einer peripheren Komponente |
| 4 | Kurzschluss zweier Steuergeräte-Pins | Verbinden zweier Steuergeräte-Pins |
| 5 | Übersprechen zwischen zwei Steuergeräte-Pins | Verbinden zweier Steuergeräte-Pins über einen Widerstand |
| 6 | Leistungsverluste durch Leckströme am Steuergeräte-Pin | Verbinden eines Steuergeräte-Pins mit plus/minus Potential der Batteriespannung (oder einer anderen Spannung) mittels eines Widerstands |

Typischerweise werden die Fehler sequentiell an den Steuergeräteanschlüssen bzw. -Pins angelegt. Dabei ist es üblich, Multiplexer einzusetzen. Hierdurch ist der Bauteileaufwand erheblich zu verringern, da nicht für jeden Kanal eine Fehlersimulations-Schaltung aufgebaut werden muss.

Es ist bekannt, Schaltungen nur in MOS-FET-Technologie oder nur in Relais-Technologie aufzubauen. Aus der nachfolgenden Tabelle 2 sind verschiedene Nachteile dieser beiden Vorgehensweisen gemäß dem Stand der Technik zu entnehmen.

**Tabelle 2**

| Nr. | Beschreibung | MOS-FET Technologie | Relais-Technologie |
|---|---|---|---|
| 1 | Schaltgeschwindigkeit | ++ Schnelles Schalten, durch Halbleiter-Technologie | -- Langsames Schalten durch verzögertes Anziehen/Abfallen des Relaiskontakts und durch Prellen. |
| 2 | Verschleiß | ++ Kein Verschleiß, da keine mechanisch bewegten Teile eingesetzt werden. | -- Verschleiß durch Mechanik und durch Abbrand der Kontakte. |
| 3 | Kosten (Schaltertechnologie ist der Hauptkostentreiber) | -- Hohe Kosten, da zwei MOS-FETs je Schaltkontakt und galvanische Trennung zwischen Ansteuerung und Nutzsignal benötigt werden. | ++ Geringe Kosten, da keine aufwendige Schaltung benötigt wird und Relais am Markt billig zu erhalten sind. |
| 4 | Problemfall Leitungsunterbrechung | -- Da nur ein hochohmischer Zustand und keine Unterbrechung zwischen Steuergeräte-Pin und Peripherie hergestellt werden kann, kommt es in manchen Fällen zu einer Fehldiagnose im Steuergerät. | ++ Durch vollständiges Trennen der Verbindung zwischen Steuergeräte-Pin und Peripherie, wird die Fehlerart immer eindeutig im Steuergerät erkannt. |

| | | | |
|---|---|---|---|
| ++ Vorteil -- Nachteil | | | |

### Offenbarung der Erfindung

Das erfindungsgemäße Verfahren zur Simulation von Fehlerzuständen in einem Steuergerät ist durch die Merkmale des Anspruchs 1 definiert.

Die erfindungsgemäße Schaltungsanordnung dient zur Simulation von Fehlerzuständen in einem Steuergerät und umfasst die Merkmale des Anspruchs 8.

Die erfindungsgemäße Schaltungsanordnung zur Fehlersimulation verfolgt das Ziel eine Kostenoptimierung und Verbesserung der Schalteigenschalten durch die Kombination von Halbleiter- und Relais-Technologie herzustellen. Dabei umfasst die Schaltungsanordnung zwei Teile:
1. Multiplexer-Schaltung
2. Fehlererzeugungs-Schaltung

In den abhängigen Ansprüchen sind Ausführungsformen des erfindungsgemäßen Verfahrens und der erfindungsgemäßen Schaltungsanordnung beschrieben.

Weitere Vorteile und Ausgestaltungen der Erfindung ergeben sich aus der Beschreibung und der beiliegenden Zeichnung.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Kurze Beschreibung der Zeichnung

Figur 1 zeigt in schematischer Darstellung eine Ausführungsform der erfindungsgemäßen Schaltungsanordnung.
Figur 2 zeigt einen Multiplexer und eine Fehlererzeugungsschaltung.
Figur 3 zeigt eine Ansteuerschaltung für die erfindungsgemäße Schaltungsanordnung.

### Ausführungsformen der Erfindung

Die Erfindung ist anhand von Ausführungsbeispielen in der Zeichnung schematisch dargestellt und wird im folgenden unter Bezugnahme auf die Zeichnung ausführlich beschrieben.

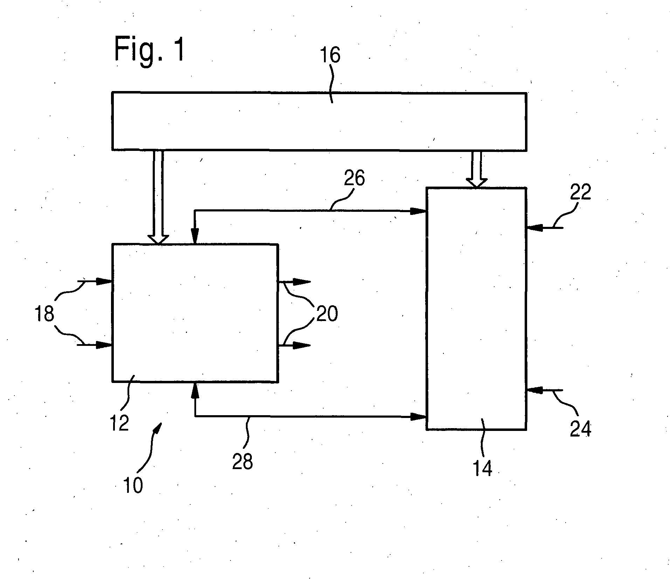

In Figur 1 ist eine Ausführungsform der erfindungsgemäßen Schaltungsanordnung in schematischer Darstellung wiedergegeben, die insgesamt mit der Bezugsziffer 10 bezeichnet ist. Zu erkennen ist ein Multiplexer 12, eine Fehlererzeugungsschaltung 14 sowie ein Mikrocontroller 16, der die Steuerung der Abläufe der Fehlersimulation und somit die Steuerung der Wechselwirkungen zwischen dem Multiplexer 12 und der Fehlererzeugungsschaltung 14 übernimmt.

Der Multiplexer 12 verfügt über eine Anzahl von Eingängen 18 für die Anschlüsse Pin 1 bis Pin X des zu überprüfenden Steuergeräts und eine Anzahl von Ausgängen 20 zur Ansteuerung der Anschlüsse von Aktoren und Sensoren.

Die Fehlererzeugungsschaltung 14 weist zwei mit Bezugsziffern 22 und 24 bezeichnete Spannungseingänge (Spannungen U1 und U2) für die erforderlichen Spannungen zur Fehlersimulation, wie bspw. eine Batteriespannung, auf.

Die Kommunikation zwischen dem Multiplexer 12 und der Fehlererzeugungsschaltung 14 erfolgt über zwei bidirektionale Signalleitungen 26 und 28, die auch als Rail1 (Bezugsziffer 26) und Rail2 (Bezugsziffer 28) bezeichnet werden.

Der Multiplexer 12 bzw. die Multiplexerschaltung ist in Relais-Technologie realisiert und die Fehlererzeugungsschaltung 14 ist in MOS-FET-Technologie implementiert. Ein Fehler wird dadurch erzeugt, dass er im ersten Schritt vorkonfiguriert und im zweiten Schritt zum gewünschten Zeitpunkt aktiviert wird. Da dieses Aktivschalten immer durch MOS-FETs realisiert werden kann, lässt sich das zeitliche Verhalten exakt steuern. Durch dieses Vorgehen können die genannten Nachteile der derzeit erhältlichen Produkte vermieden werden.

### Nachteil Nr. 1 Schaltgeschwindigkeit:

Da der Fehler immer durch MOS-FETs aktiv geschalten wird, ist das zeitliche Verhalten definiert und die Schaltgeschwindigkeit entsprechend hoch (Größenordnung 20 µs).

### Nachteil Nr. 2 Verschleiß:

Typischerweise werden alle angeschlossenen Steuergeräte-Pins der Reihe nach fehlersimuliert. Die Fehlererzeugungsschaltung 14 muss bei jedem Fehler in einen Fehlerzustand und wieder zurück in den Ausgangszustand schalten. Bei den Multiplexer-Relais wird ein Kanal nur wenige Male pro Simulationsdurchlauf benötigt, die Schaltspiele je Relais sind entsprechend gering. Im Vergleich zu der Multiplexerschaltung 12 muss die Fehlererzeugungsschaltung 14 viel häufiger schalten. Da die Fehlererzeugungsschaltung 14 in MOS-FET-Technologie und die Multiplexerschaltung 12 in Relais-Technologie realisiert wird, ist der Verschleiß minimiert.

### Nachteil Nr. 3 Kosten:

Der Multiplexer 12 wird in der kostengünstigen Relais-Technologie ausgeführt. Für die Fehlererzeugungsschaltung 14 werden lediglich 12 MOS-FETs (jeweils in Zweiergruppen) benötigt. Wird bspw. ein Produkt mit 64 Kanälen angeboten, werden 192 Relais und 12 MOS-FETs benötigt. Dadurch werden die Kosten minimiert.

### Nachteil Nr. 4 Problemfall Leistungsunterbrechung:

Die Leistungsunterbrechung ist redundant in MOS-FET- und Relais-Technologie ausgeführt. Damit kann von Fall zu Fall die eine oder andere Technologie eingesetzt werden.

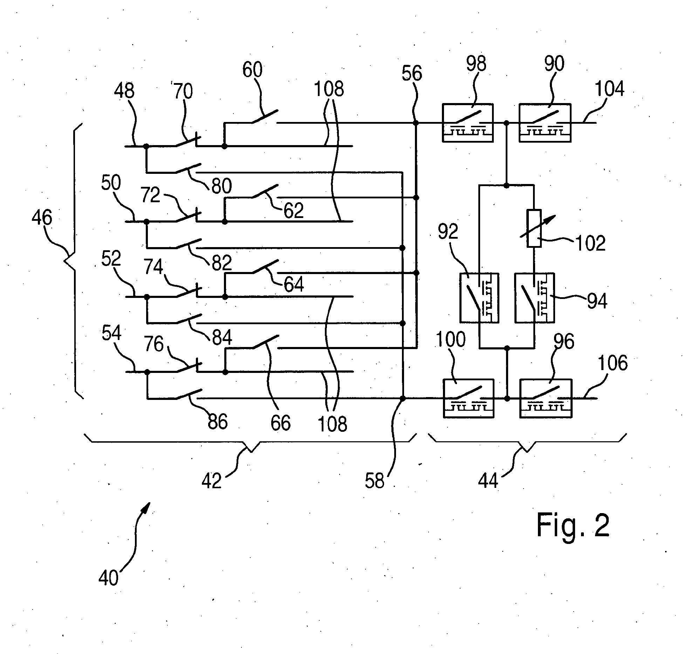

In Figur 2 ist eine Schaltungsanordnung 40 mit einem Multiplexer 42 und einer Fehlererzeugungsschaltung 44 zur Fehlersimulation dargestellt.

Der Multiplexer 42 umfasst vier Eingangskanäle 46 für die Steuergerätanschlüsse Pin 1 (Bezugsziffer 48), Pin 2 (Bezugsziffer 50), Pin 3 (Bezugsziffer 52) und Pin 4 (Bezugsziffer 54). Die Verbindungen zu der Fehlererzeugungsschaltung sind mit Rail1 (Bezugsziffer 56) und Rail2 (Bezugsziffer 58) gegeben. Diese Fehler-Rails 56 und 58 stellen die Verbindung zwischen dem Ausgang des Multiplexers 42 und dem Eingang der Fehlererzeugungsschaltung 44 dar.

Die Multiplexer-Relais K11 (Bezugsziffer 60), K21 (Bezugsziffer 62), K31 (Bezugsziffer 64) und K41 (Bezugsziffer 66) sind für Rail1 56 vorgesehen. Im bestromten Zustand schalten diese Relais das Steuergerätesignal auf Rail1 56.

Die Multiplexer-Relais K12 (Bezugsziffer 70), K22 (Bezugsziffer 72), K32 (Bezugsziffer 74) und K42 (Bezugsziffer 7,6) dienen als Unterbrecherrelais. Diese Relais unterbrechen im bestromten Zustand den Signalfluss zwischen Steuergeräte-Pin und Sensor/Aktor.

Die Multiplexer-Relais K13 (Bezugsziffer 80), K23 (Bezugsziffer 82), K33 (Bezugsziffer 84) und K43 (Bezugsziffer 86) sind für Rail2 vorgesehen. Im bestromten Zustand schalten diese Relais das Steuergerätesignal auf Rail2 58.

Die Fehlererzeugungsschaltung 44 umfasst sechs MOS-FETs M1 (Bezugsziffer 90), M2 (Bezugsziffer 92), M3 (Bezugsziffer 94), M4 (Bezugsziffer 96), M5 (Bezugsziffer 98) und M6 (Bezugsziffer 100). Diese realisieren die Fehlererzeugungsschaltung 44.

Weiterhin ist eine Widerstandskaskade R_{kaskade} vorgesehen, die mit der Bezugsziffer 102 bezeichnet ist. Diese Widerstandskaskade 102 wird für Fehler eingesetzt, die eine Widerstandssimulation benötigen.

Außerdem sind ein erster Spannungseingang 104 für eine Spannung U1 und ein zweiter Spannungseingang 106 für eine Spannung U2 vorgesehen. Diese Spannungen werden zur Simulation von Fehlern, die eine externe Spannung erfordern, benötigt. Typischerweise wird hierbei die Spannung der Fahrzeugbatterie oder eines Konstanters angeschlossen. Es kann jedoch auch jede andere beliebige Spannungsquelle genutzt werden. An Ausgängen 108 sind Sensoren und Aktoren angeschlossen.

Die dargestellte Schaltungsanordnung 40 ist geeignet, alle Fehlerarten, die dem Stand der Technik entsprechen (siehe Tabelle 1), zu realisieren bzw. zu simulieren. Da diese Fehler mit MOS-FETs geschaltet werden, ist das zeitliche Verhalten für die Echtzeit-Fehlersimulation geeignet.

Die einzelnen Fehler werden anhand des Schaltbilds in Figur 2 erläutert. Hierbei wird zwischen Fehlerkonfiguration und Fehleraktivierung unterschieden. Die Fehlerkonfiguration wird benötig, um den Fehlerfall vorzubereiten, das Steuergerät stellt aber keine Veränderung am Signalverhalten fest. Die Fehleraktivierung verändert dann das Signalverhalten am Steuergeräte-Pin, das Steuergerät kann jetzt einen Fehler erkennen.

Um die Beschreibung allgemein zu halten, wird bei den Relais des Multiplexers die erste Ziffer des Relaisnamens durch ein "X" ersetzt wobei das X für die Kanal-Nummer steht, die prinzipiell beliebig groß sein kann. Bei der Fehleraktivierung ist auf die angegebene Reihenfolge zu achten, damit der Signalfluss in der gewünschten Art und Weise erfolgt.

### Kein Fehler aktiv:

Dies ist der Default-Zustand, wenn kein Fehler aktiv ist. Alle Relais der Multiplexer-Schaltung 42 sind im stromlosen Zustand, alle MOS-FETs sind im gesperrten Zustand. Es wird der Signalfluss zwischen Steüergeräte-Pin und Sensor/Aktor über die Relais K12, K22 ... hergestellt.

### Fehlerart 1: Leistungsunterbrechung

### A. Leitungsunterbrechung über Relais (dieses Beispiel fällt nicht unter die beanspruchte Erfindung)

### Fehlerkonfiguration

Für diesen Fall ist keine Konfiguration notwendig.

### Fehleraktivierung

Das Öffner-Relais KX2 wird bestromt und unterbricht somit den Signalfluss zwischen Steuergeräte-Pin und Sensor/Aktor.

### B. Leitungsunterbrechung über MOS-FET

### Fehlerkonfiguration

- Die Relais KX1 und KX3 werden bestromt und stellen somit eine Verbindung zu Rail1 56 und Rail2 58 her.
- Die MOS-FET M5 98, M2 92, M6 100 werden leitend und verbinden somit Rail1 56 mit Rail2 58. Damit wird bewirkt, dass der Signalfluss zwischen Steuergeräte-Pin und Sensor/Aktor sowohl über Relais KX2 als auch über die Rail-Leitungen 56 und 58 hergestellt wird.
- Das Relais KX2 wird bestromt, was bewirkt, dass der Öffner-Kontakt des Relais öffnet. Der Signalfluss zwischen Steuergeräte-Pin und Sensor/Aktor wird jetzt nur über die Rail-Leitungen 56 und 58 hergestellt.

### Fehleraktivierung

MOS-FET M2 92 wird geöffnet. Nun ist der Signalfluss zwischen Steuergeräte-Pin und Sensor/Aktor unterbrochen.

### Fehlerart 2: Kurzschluss auf plus/minus Potential der Batteriespannung (oder einer anderen Spannung)

### Fehlerkonfiguration

### 1. Fall Fehlersimulation über U1 104

Relais KX1 wird bestromt und MOS-FET M5 98 wird leitend.

### 2. Fall Fehlersimulation über U2 106

Relais KX3 wird bestromt und MOS-FET M6 100 wird leitend.

### Fehleraktivierung

### 1. Fall Fehlersimulation über U1 104

MOS-FET M1 90 wird leitend.

### 2. Fall Fehlersimulation über U2 106

MOS-FET M4 96 wird leitend.

### Fehlerart 3: Kontaktkorrosion am Steuergeräte-Pin

### Fehlerkonfiguration

- Die Relais KX1 und KX3 werden bestromt und stellen somit eine Verbindung zu Rail1 56 und Rail2 58 her.
- MOS-FETs M5 98, M2 92, M6 100 werden leitend und verbinden somit Rail1 56 mit Rail2 58. Damit wird bewirkt, dass der Signalfluss zwischen Steuergeräte-Pin und Sensor/Aktor sowohl über Relais KX2 als auch über die Rail-Leitungen 56 und 58 hergestellt wird.
- Das Relais KX2 wird bestromt, was bewirkt, dass der Öffner-Kontakt des Relais öffnet. Der Signalfluss zwischen Steuergeräte-Pin und Sensor/Aktor wird jetzt nur über die Rail-Leitungen hergestellt.
- An der Widerstandskaskade 102 wird der gewünschte Widerstandswert eingestellt.

### Fehleraktivierung

MOS-FET M2 92 wird gesperrt und MOS-FET M3 94 wird zur gleichen Zeit leitend.

### Fehlerart 4: Kurzschluss zweier Steuergeräte-Pins

### Fehlerkonfiguration

- Der erste Steuergeräte-Pin wird durch die Bestromung von KX1 auf Rail1 56 gelegt.
- Der zweite Steuergeräte-Pin wird durch Bestromung von KX3 auf Rail2 58 gelegt.
- MOS-FETs M6 100 und M5 98 werden leitend.

### Fehleraktivierung

MOS-FET M2 92 wird leitend.

### Fehlerart 5: Übersprechen zwischen zwei Steuergeräte-Pins

### Fehlerkonfiguration

- Der erste Steuergeräte-Pin wird durch die Bestromung von KX1 auf Rail1 56 gelegt.
- Der zweite Steuergeräte-Pin wird durch Bestromung von KX3 auf Rail2 58 gelegt.
- MOS-FETs M6 100 und M5 98 werden leitend.
- Die Widerstandskaskade 102 wird auf den gewünschten Wert eingestellt.

### Fehleraktivierung

MOS-FET M3 94 wird leitend.

### Fehlerart 6: Leistungsverluste durch Leckströme am Steuergeräte-Pin

### Fehlerkonfiguration

- Die Relais KX1 und KX3 werden bestromt und stellen somit eine Verbindung zu Rail1 56 und Rail2 58 her.
- MOS-FETs M5 98, M2 92, M6 100 werden leitend und verbinden somit Rail1 56 mit Rail2 58. Damit wird bewirkt, dass der Signalfluss zwischen Steuergeräte-Pin und Sensor/Aktor sowohl über Relais KX2 als auch über die Rail-Leitungen 56 und 58 hergestellt wird.
- Das Relais KX2 wird beströmt, was bewirkt, dass der Öffner-Kontakt des Relais öffnet. Der Signalfluss zwischen Steuergeräte-Pin und Sensor/Aktor wird jetzt nur über die Rail-Leitungen hergestellt.
- An der Widerstandskaskade 102 wird der gewünschte Widerstandswert eingestellt.

### Fehleraktivierung

Die Leckströme können entweder über U1 oder über U2 fließen.

### 1. Fall: Leckstrom fließt über U1 104

M5 98 und M2 92 werden gesperrt.

M3 94 und M1 90 werden leitend.

### 2. Fall: Leckstrom fließt über U1 104

M6 100 und M2 92 werden gesperrt.

M3 94 und M4 96 werden leitend.

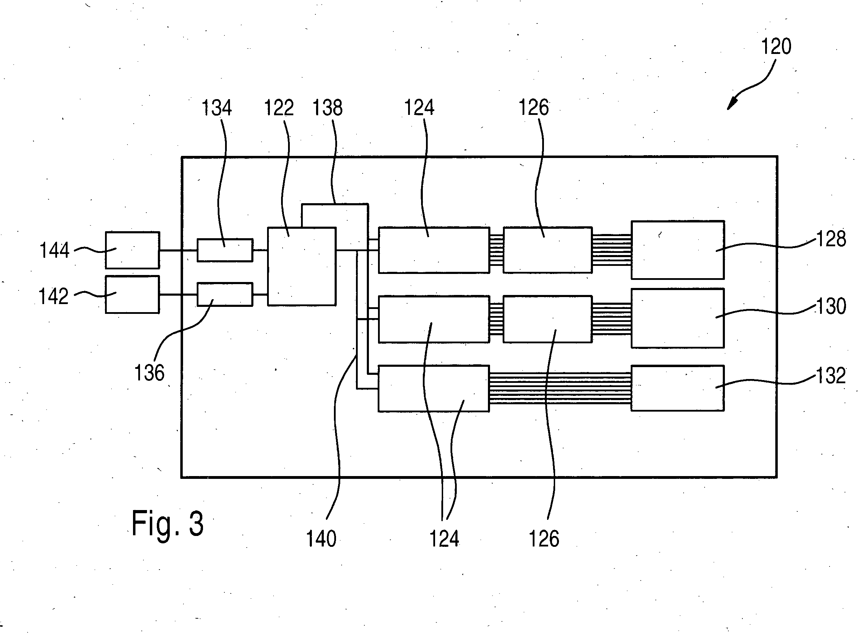

In Figur 3 ist eine Ansteuerschaltung 120 zur Ansteuerung der erfindungsgemäßen Schaltungsanordnung dargestellt. In dieser ist ein Mikrocontroller 122, drei Schieberegister 124, zwei Relais-Treiber 126, ein Multiplexer-Relais 128, eine Relais-Widerstandskaskade 130, ein MOS-FET 132, eine Etherneteinrichtung 134 und ein CAN-Bus-Übertrager 136 enthalten. Die interne Kommunikation erfolgt über eine Aktivierungsleitung 138 und einen seriellen Bus 140. Die Ansteuerschaltung ist an einem CAN-Bus 142 oder einem Ethernet 144 zu betreiben.

Die Kommunikation zwischen einem Fehlersimulations-Gerät und einem übergeordneten Leitrechner erfolgt über CAN 142 oder Ethernet 144. Durch die Firmware im Mikrocontroller 122 des Fehlersimulations-Geräts ist das System in der Lage, alle oben genannten Fehter zu realisieren. Typischerweise kommuniziert der Mikrocontroller 122 über ein serielles Protokoll mit Schieberegistern 124. Diese Register 124 wandeln einen seriellen Bitstrom in Signale um, die parallel an den Ausgangs-Pins des Registers anliegen. Um ein gleichzeitiges Anlegen der Signale an allen Pins der Schieberegister 124 zu gewährleisten, muss auf der Aktivierungsleitung 138 eine Flanke von dem Mikrocontroller 122 ausgelöst werden. Die Parallelsignale an den Registern 138 werden durch die Relaistreiber 126 verstärkt und damit die Relais 128 geschaltet.

## Patentansprüche

1. Verfahren zur Simulation von Fehlerzuständen in einem Steuergerät, bei dem Anschlüsse (18) des zu überprüfenden Steuergeräts über einen Multiplexer (12, 42) über zwei bidirektionale Signalleitungen (26, 28) mit einer Fehlererzeugungsschaltung (14, 44) verbunden werden, wobei der Multiplexer (12, 42) in einer mechanischen Relais-Technologie realisiert wird und Eingänge (18) für die Anschlüsse des zu überprüfenden Steuergeräts und Ausgänge (20) zur Ansteuerung von Anschlüssen von Sensoren und Aktoren aufweist und die Fehlererzeugungsschaltung (14, 44) in einer Halbleiter-Technologie mit MOS-FET implementiert wird und zwei Spannungseingänge (22, 24) für erforderliche Spannungen zur Fehlersimulation aufweist, bei dem zur Simulation des jeweiligen Fehlerzustandes in einem ersten Schritt ein Fehler durch Schalten von Relais des Multiplexers (12, 42) und MOS-FET der Fehlererzeugungsschaltung (14, 44) vorkonfiguriert wird, wobei das Steuergerät aber keine Veränderung am Signalverhalten feststellt und in einem zweiten Schritt dieser Fehler zu einem gewünschten Zeitpunkt ausschließlich durch Schalten von MOS-FET der Fehlererzeugungsschaltung (14, 44) aktiviert wird, wodurch das Signalverhalten am Steuergerät verändert wird, so dass das Steuergerät einen Fehler erkennt.

2. Verfahren nach Anspruch 1, bei dem eine Leitungsunterbrechung simuliert wird.

3. Verfahren nach Anspruch 1, bei dem ein Kurzschluss auf einem Potential einer Spannung simuliert wird.

4. Verfahren nach Anspruch 1, bei dem eine Kontaktkorrosion an einem Steuergeräteanschluss simuliert wird.

5. Verfahren nach Anspruch 1, bei dem ein Kurzschluss zweier Steuergeräteanschlüsse simuliert wird.

6. Verfahren nach Anspruch 1, bei dem ein Übersprechen zwischen zwei Steuergeräteanschlüssen simuliert wird.

7. Verfahren nach Anspruch 1, bei dem Leitungsverluste durch Leckströme an einem Steuergeräteanschluss simuliert werden.

8. Schaltungsanordnung zur Simulation von Fehlerzuständen in einem Steuergerät mit einem Multiplexer (12, 42) und einer Fehlererzeugungsschaltung (14, 44), die über zwei bidirektionale Signalleitungen (26, 28) miteinander verbunden sind, wobei der Multiplexer Eingänge (18) für die Anschlüsse des zu überprüfenden Steuergeräts und Ausgänge (20) zur Ansteuerung von Aktoren und Sensoren aufweist, wobei der Multiplexer (12, 42) in einer mechanischen Relais-Technologie realisiert ist und die Fehlererzeugungsschaltung (14, 44) in einer Halbleiter-Technologie mit MOS-FET implementiert ist, und zwei Spannungseingänge (12, 44) für erforderliche Spannungen zur Fehlersimulation aufweist, mit Mitteln durch die zur Simulation des jeweiligen Fehlerzustandes in einem ersten Schritt ein Fehler durch Schalten von Relais des Multiplexers (12, 44) und MOS-FET der Fehlererzeugungsschaltung (14, 44) vorkonfiguriert wird, wobei das Steuergerät aber keine Veränderung am Signalverhalten feststellt und in einem zweiten Schritt dieser Fehler zu einem gewünschten Zeitpunkt ausschließlich durch Schalten von MOS-FET der Fehlererzeugungsschaltung (14, 44) aktiviert wird wodurch das Signalverhalten am Steuergerät verändert wird, so dass das Steuergerät einen Fehler erkennt.

9. Schaltungsanordnung nach Anspruch 8, wobei Mittel vorhanden sind, durch die eine Leitungsunterbrechung simuliert wird.

10. Schaltungsanordnung nach Anspruch 8, wobei Mittel vorhanden sind, durch die ein Kurzschluss auf einem Potential einer Spannung simuliert wird.

11. Schaltungsanordnung nach Anspruch 8, wobei Mittel vorhanden sind, durch die eine Kontaktkorrosion an einem Steuergeräteanschluss simuliert wird.

12. Schaltungsanordnung nach Anspruch 8, wobei Mittel vorhanden sind, durch die ein Kurzschluss zweier Steuergeräteanschlüsse simuliert wird.

13. Schaltungsanordnung nach Anspruch 8, wobei Mittel vorhanden sind, durch die ein Übersprechen zwischen zwei Steuergeräteanschlüssen simuliert wird.

14. Schaltungsanordnung nach Anspruch 8, wobei Mittel vorhanden sind, durch die Leitungsverluste durch Leckströme an einem Steuergeräteanschluss simuliert werden.

## Claims

1. Method for simulating fault states in a control device, in which connections (18) of the control device to be checked are connected to a fault generation circuit (14, 44) via a multiplexer (12, 42) using two bidirectional signal lines (26, 28), the multiplexer (12, 42) being implemented using a mechanical relay technology and having inputs (18) for the connections of the control device to be checked and outputs (20) for controlling connections of sensors and actuators, and the fault generation circuit (14, 44) being implemented using a semiconductor technology with MOSFETs and having two voltage inputs (22, 24) for required voltages for fault simulation, in which, in order to simulate the respective fault state, a fault is preconfigured in a first step by switching relays of the multiplexer (12, 42) and MOSFETs of the fault generation circuit (14, 44), the control device not detecting a change in the signal behaviour, however, and this fault being activated in a second step at a desired time solely by switching MOSFETs of the fault generation circuit (14, 44), as a result of which the signal behaviour at the control device is changed, with the result that the control device detects a fault.

2. Method according to Claim 1, in which a line interruption is simulated.

3. Method according to Claim 1, in which a short circuit at a voltage potential is simulated.

4. Method according to Claim 1, in which contact corrosion at a control device connection is simulated.

5. Method according to Claim 1, in which a short circuit of two control device connections is simulated.

6. Method according to Claim 1, in which crosstalk between two control device connections is simulated.

7. Method according to Claim 1, in which line losses as a result of leakage currents at a control device connection are simulated.

8. Circuit arrangement for simulating fault states in a control device, having a multiplexer (12, 42) and a fault generation circuit (14, 44) which are connected to one another using two bidirectional signal lines (26, 28), the multiplexer having inputs (18) for the connections of the control device to be checked and outputs (20) for controlling actuators and sensors, the multiplexer (12, 42) being implemented using a mechanical relay technology, and the fault generation circuit (14, 44) being implemented using a semiconductor technology with MOSFETs and having two voltage inputs (22, 24) for required voltages for fault simulation, having means which are used to preconfigure a fault in a first step, in order to simulate the respective fault state, by switching relays of the multiplexer (12, 42) and MOSFETs of the fault generation circuit (14, 44), the control device not detecting a change in the signal behaviour, however, and this fault being activated in a second step at a desired time solely by switching MOSFETs of the fault generation circuit (14, 44), as a result of which the signal behaviour at the control device is changed, with the result that the control device detects a fault.

9. Circuit arrangement according to Claim 8, wherein means are provided and are used to simulate a line interruption.

10. Circuit arrangement according to Claim 8, wherein means are provided and are used to simulate a short circuit at a voltage potential.

11. Circuit arrangement according to Claim 8, wherein means are provided and are used to simulate contact corrosion at a control device connection.

12. Circuit arrangement according to Claim 8, wherein means are provided and are used to simulate a short circuit of two control device connections.

13. Circuit arrangement according to Claim 8, wherein means are provided and are used to simulate crosstalk between two control device connections.

14. Circuit arrangement according to Claim 8, wherein means are provided and are used to simulate line losses as a result of leakage currents at a control device connection.

## Revendications

1. Procédé pour la simulation d'états d'erreur dans un appareil de commande, dans lequel des bornes (18) de l'appareil de commande à tester sont connectées par l'intermédiaire d'un multiplexeur (12, 42) au moyen de deux lignes de signaux bidirectionnelles (26, 28) à un circuit générateur d'erreur (14, 44), dans lequel le multiplexeur (12, 42) est réalisé conformément à une technologie du type relais mécanique et comprend des entrées (18) destinées aux bornes de l'appareil de commande à tester et des sorties (20) destinées à commander des bornes de capteurs et d'actionneurs et le circuit générateur d'erreur (14, 44) est réalisé conformément à une technologie de semi-conducteur de type MOS-FET et comprend deux entrées de tension (22, 24) destinées à des tensions nécessaires à la simulation d'erreur, dans lequel lors d'une première étape destinée à la simulation de l'état d'erreur respectif, une erreur est préconfigurée par commutation de relais du multiplexeur (12, 42) et du MOS-FET du circuit générateur d'erreur (14, 44), dans lequel l'appareil de commande ne détecte cependant aucune modification du comportement des signaux et, lors d'une seconde étape, cette erreur n'est activée à un instant souhaité que par commutation du MOS-FET du circuit générateur d'erreur (14, 44), cela ayant pour résultat que le comportement des signaux est modifié dans l'appareil de commande, de telle sorte que l'appareil de commande détecte une erreur.

2. Procédé selon la revendication 1, dans lequel une interruption de ligne est simulée.

3. Procédé selon la revendication 1, dans lequel un court-circuit au potentiel d'une tension est simulé.

4. Procédé selon la revendication 1, dans lequel une corrosion des contacts sur une borne de l'appareil de commande est simulée.

5. Procédé selon la revendication 1, dans lequel un court-circuit de deux bornes de l'appareil de commande est simulé.

6. Procédé selon la revendication 1, dans lequel une diaphonie entre deux bornes de l'appareil de commande est simulée.

7. Procédé selon la revendication 1, dans lequel des pertes de puissance dues à des courants de fuite sont simulées sur une borne de l'appareil de commande.

8. Circuit pour la simulation d'états d'erreur dans un appareil de commande, comprenant un multiplexeur (12, 42) et un circuit générateur d'erreur (14, 44) qui sont connectés l'un à l'autre par l'intermédiaire de deux lignes de signaux bidirectionnelles (26, 28), dans laquelle le multiplexeur comprend des entrées (18) destinées aux bornes de l'appareil de commande à tester et des sorties (20) destinées à commander des actionneurs et des capteurs, dans lequel le multiplexeur (12, 42) est réalisé conformément à une technologie du type relais mécanique et le circuit générateur d'erreur (14, 44) est réalisé conformément à une technologie de semi-conducteur de type MOS-FET, et comprend deux entrées de tension (22, 24) destinées à des tensions nécessaires à la simulation d'erreur, comportant des moyens à l'aide desquels, lors d'une première étape destinée à la simulation de l'état d'erreur respectif, une erreur est préconfigurée par commutation de relais du multiplexeur (12, 42) et du MOS-FET du circuit générateur d'erreur (14, 44), dans lequel l'appareil de commande ne détecte cependant aucune modification du comportement des signaux et, lors d'une seconde étape, cette erreur n'est activée à un instant souhaité que par commutation du MOS-FET du circuit générateur d'erreur (14, 44), cela ayant pour résultat que le comportement des signaux est modifié dans l'appareil de commande, de telle sorte que l'appareil de commande détecte une erreur.

9. Circuit selon la revendication 8, dans lequel il est prévu des moyens à l'aide desquels une interruption de ligne est simulée.

10. Circuit selon la revendication 8, dans lequel il est prévu des moyens à l'aide desquels un court-circuit au potentiel d'une tension est simulé.

11. Circuit selon la revendication 8, dans lequel il est prévu des moyens à l'aide desquels une corrosion des contacts sur une borne de l'appareil de commande est simulée.

12. Circuit selon la revendication 8, dans lequel il est prévu des moyens à l'aide desquels un court-circuit de deux bornes de l'appareil de commande est simulé.

13. Circuit selon la revendication 8, dans lequel il est prévu des moyens à l'aide desquels une diaphonie entre deux bornes de l'appareil de commande est simulée.

14. Circuit selon la revendication 8, dans lequel il est prévu des moyens à l'aide desquels des pertes de puissance dues à des courants de fuite sont simulées sur une borne de l'appareil de commande.
